# EUROPEAN PATENT APPLICATION

(11) **EP 2 426 706 A1**
(43) Date of publication of application: **07.03.2012**
(21) Application number: 10769581.9
(22) Date of filing: 26.03.2010
(51) Int. Cl.: H01L 21/337, H01L 29/808

(54) **TRANSVERSE JUNCTION FIELD EFFECT TRANSISTOR**

(30) Priority: 01.05.2009 JP 2009112135
(71) Applicant: Sumitomo Electric Industries, Ltd., Chuo-ku Osaka-shi Osaka 541-0041 (JP)
(72) Inventor: FUJIKAWA, Kazuhiro, Osaka-shi Osaka 554-0024 (JP); HARADA, Shin, Osaka-shi Osaka 554-0024 (JP); NAMIKAWA, Yasuo, Osaka-shi Osaka 554-0024 (JP)
(74) Representative: Grünecker, Kinkeldey, Stockmair & Schwanhäusser
(86) International application number: PCT/JP2010/055403
(87) International publication number: WO 2010/125882

(57) **Abstract**

A lateral junction field-effect transistor capable of preventing the occurrence of leakage current and realizing a sufficient withstand voltage can be provided. In a lateral JFET (10) according to the present invention, a buffer layer (11) is located on a main surface of a SiC substrate (1) and includes a p-type impurity. A channel layer (12) is located on the buffer layer (11) and includes an n-type impurity having a higher concentration than the concentration of the p-type impurity in the buffer layer (11). A source region (15) and a drain region (16) are of n-type and formed to be spaced from each other in a surface layer of the channel layer (12), and a p-type gate region (17) is located in the surface layer of the channel layer (12) and between the source region (15) and the drain region (16). A barrier region (13) is located in an interface region between the channel layer (12) and the buffer layer (11) and in a region located under the gate region (17) and includes a p-type impurity having a higher concentration than the concentration of the p-type impurity in the buffer layer (11).

## Description

### TECHNICAL FIELD

The present invention relates to a lateral junction field-effect transistor, and more particularly to a lateral junction field-effect transistor in which the generation of leakage current can be prevented and a high withstand voltage can be achieved.

### BACKGROUND ART

A lateral Junction Field-Effect Transistor (lateral JFET) is conventionally known as one of semiconductor devices. A lateral JFET is one type of a junction field-effect transistor in which a pn junction is provided in the vicinity of a channel region where carriers flow through, and a reverse bias voltage is applied from a gate electrode to spread a depletion layer from the pn junction into the channel region, thereby controlling the conductance of the channel region to perform an operation such as switching. In particular, a lateral JFET refers to the one in which carriers move in the channel region in parallel with the surface of the device. For instance, Japanese Patent Laying-Open No. 2004-221168 (hereinafter referred to as Patent Document 1) discloses a lateral JFET which includes a semiconductor substrate, a buffer layer of a first conductivity type formed on the semiconductor substrate, a channel layer of a second conductivity type formed on the buffer layer, and a source region of the second conductivity type, a drain region, and a gate region of the first conductivity type formed in a surface layer of the channel layer, and in which a barrier region having a higher first-conductivity-type impurity concentration than that of the buffer layer is formed on the surface of buffer layer facing the channel layer. In such a lateral JFET, a junction (pn junction) is formed between the drain region and the barrier region. Then, application of a high reverse bias voltage to this junction will produce a shorter length of extension of a depletion layer into the barrier region side (depletion layer width) than the length of extension of the depletion layer into the buffer region side (depletion layer width) when the buffer layer and the drain region form a direct junction. This prevents the depletion layer from extending so close to the source region that the depletion layer may draw carriers from the source region across a portion of the buffer layer beneath the channel region. That is, the extension of the depletion layer in barrier region along the channel region is suppressed, and therefore, carriers are injected from the source region into the buffer layer and leakage current to the drain can be prevented.

### PRIOR ART DOCUMENTS

### PATENT DOCUMENTS

Patent Document 1: Japanese Patent Laying-Open No. 2004-221168

### SUMMARY OF THE INVENTION

### PROBLEMS TO BE SOLVED BY THE INVENTION

The above-described conventional lateral JFET, however, suffered from a problem that with a barrier region formed below a drain region, the extension of a depletion layer from the drain region is limited by the barrier region, and a withstand voltage is reduced as compared to without such a barrier region.

The present invention has been made for solving the above-described problem, and an object of the present invention is to provide a lateral junction field-effect transistor in which the generation of leakage current can be prevented and a sufficient withstand voltage can be realized.

### MEANS FOR SOLVING THE PROBLEMS

A lateral junction field-effect transistor (lateral JFET) according to the present invention includes a semiconductor substrate, a buffer layer, a channel layer, a source region, a drain region, a gate region, and a barrier region. The buffer layer is located on a main surface of the semiconductor substrate and includes an impurity of a first conductivity type. The channel layer is located on the buffer layer and includes an impurity of a second conductivity type having a higher concentration than the concentration of the impurity of the first conductivity type in the buffer layer. The source and drain regions are formed to be spaced from each other in a surface layer of the channel layer and include an impurity of the second conductivity type. The gate region is located in the surface layer of the channel layer and between the source region and the drain region and includes the impurity of the first conductivity type. The barrier region is arranged in an interface region between the channel layer and the buffer layer and in either a region located under the gate region or a region extending from under the gate region to under the source region and includes an impurity of the first conductivity type having a higher concentration than the concentration of the impurity of the first conductivity type in the buffer layer.

As such, a junction (pn junction) is formed between the barrier region including the impurity of the first conductivity type and a surrounding region including the impurity of the second conductivity type (for example, a drain-region-side portion of the channel layer). The impurity of the first conductivity type in the barrier region in this pn junction has a higher concentration than the concentration of the impurity of the first conductivity type in the buffer layer. This results in that even when a high reverse bias voltage is applied to the junction, the length of extension of the depletion layer into the barrier region side (depletion layer width) is shorter than that of when the buffer layer and the channel layer form a direct pn junction. Further, since the barrier region is formed under the gate region or under the gate and source regions, the depletion layer can be suppressed so as not to extend so close to the source region that the depletion layer may draw carriers from this source region across the buffer region beneath the channel region. Further, the impurity concentration in the barrier region can be determined (for example, in consideration of correlation with impurity concentrations in other regions) such that the scope of expansion of the depletion layer is restricted so as not to generate drawing of carriers in the depletion layer. As such, since the extension of the depletion layer in the barrier region along the bottom of the channel region is suppressed, the barrier region acts as a potential barrier for carriers. Consequently, leak current to the drain region, which results from a carrier injection from the source region into the buffer layer, can be prevented.

Further, the above-described barrier region is not formed in a region under the drain region. Thus, in the region under the drain region, there is no limitation of the extension of the depletion layer caused by the presence of such barrier region. This can prevent the occurrence of a problem of a reduced withstand voltage which would arise if there were a barrier region in the region under the drain region. It is noted that the above-described barrier region may be formed in a surface layer of the buffer layer and may be formed as a thin film layer stacked on the buffer layer.

### EFFECTS OF THE INVENTION

According to the present invention, a lateral junction field-effect transistor capable of preventing the generation of a leakage current and realizing a sufficient withstand voltage can be achieved.

### BRIEF DESCRIPTION OF THE DRAWINGS

Fig. 1 is a cross section schematically showing a first embodiment of a lateral junction field-effect transistor according to the present invention.
Fig. 2 is a cross section schematically showing a modification of a lateral junction field-effect transistor shown in Fig. 1.
Fig. 3 is a cross section schematically showing a second embodiment of a lateral junction field-effect transistor according to the present invention.
Fig. 4 is a cross section schematically showing a modification of a lateral junction field-effect transistor shown in Fig. 3.

### MODES FOR CARRYING OUT THE INVENTION

Embodiments of the present invention will be described hereinafter with reference to the drawings. In the drawings below, the same or corresponding elements have the same reference numbers allotted, and description thereof will not be repeated.

### First Embodiment

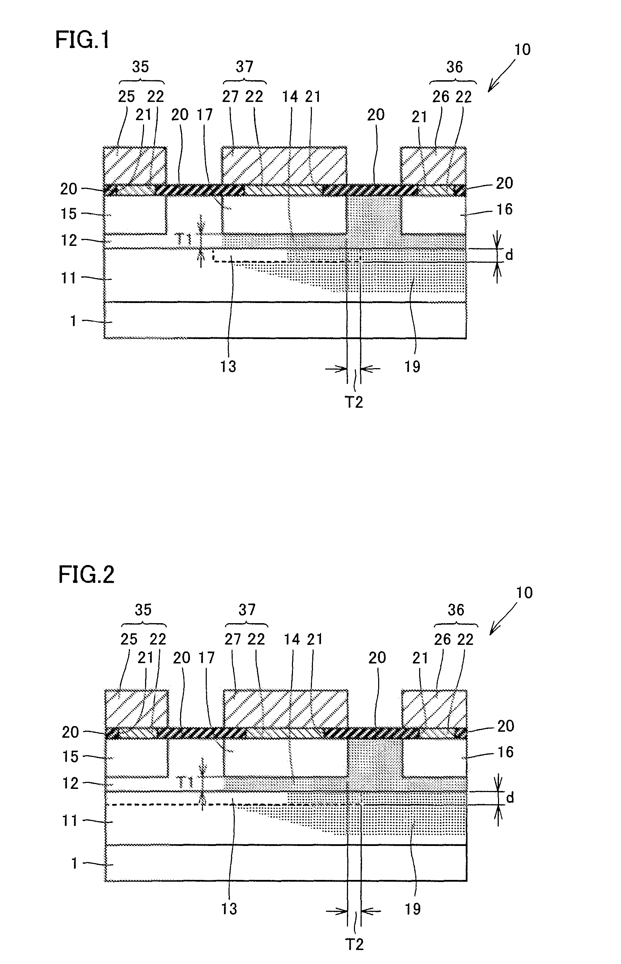

Referring to Fig. 1, a first embodiment of a lateral junction filed-effect transistor (lateral JFET) 10 according to the present invention will be described. In lateral JFET 10 shown in Fig. 1, a p-type buffer layer 11 is formed on a SiC substrate 1. In an upper surface layer (a surface layer opposite to the surface facing SiC substrate 1) of the buffer layer 11, a barrier region 13 of p-type conductivity having a thickness d is formed. Barrier region 13 is arranged in a region located under a gate region 17, which will be described later. Barrier region 13 has a higher p-type impurity concentration than the p-type impurity concentration of buffer layer 11. On barrier region 13, a channel layer 12 including a channel region 14 and having n-type conductivity is formed. Further, on channel region 14, a p⁺-type gate region 17 (namely, of p-type conductivity and with a higher p-type impurity concentration than the p-type impurity concentration in buffer layer 11 and barrier region 13) is arranged. A source region 15 which is an n⁺-type region (namely, of n-type conductivity and with a higher n-type impurity concentration than the n-type impurity concentration in channel layer 12) and an n⁺-type drain region 16 are arranged such that gate region 17 is interposed therebetween.

On the top surface of channel layer 12, a field oxide film 20 having a plurality of openings 21 is formed. A plurality of openings 21 are formed to be located on gate region 17, source region 15, and drain region 16, respectively. Within opening 21 located above gate region 17, an ohmic electrode 22 is formed. Further, ohmic electrodes 22 are also formed within openings 21 located above source region 15 and drain region 16, respectively. Above gate region 17, a gate pad 27 made of a conductive material such as metal is formed on ohmic electrode 22. Further, above source region 15, a source pad 25 made of a conductive material is formed on ohmic electrode 22. Further, above drain region 16, a drain pad 26 made of a conductive material is formed on ohmic electrode 22. Ohmic electrode 22 on gate region 17 and gate pad 27 constitute a gate electrode 37. Ohmic electrode 22 on source region 15 and source pad 25 constitute a source electrode 35. Ohmic electrode 22 on drain region 16 and drain pad 26 constitute a drain electrode 36.

Here, barrier region 13 forming a pn junction with channel layer 12 in the vicinity of drain region 16 has a higher impurity concentration than the impurity concentration of buffer layer 11. This result in that a depletion layer 19 has a smaller extension width into barrier region 13 than the conventional extension width into buffer layer 11. For example, given that barrier region 13 has an impurity concentration of α times the impurity concentration of buffer layer 11, then the length of depletion layer 19 (extending toward source region) along channel region within barrier region 13 can be determined as 1/(α^{1/2}) times the length of depletion layer within the buffer layer. This suppresses drawings of carriers from source region 15 via a tip portion of the above-described depletion layer 19 to drain region 16. That is, when a high voltage is applied to drain region 16, the above-described barrier region 13 serves as a potential barrier for carriers since the extension of depletion layer 19 along channel region 14 in barrier region 13 is suppressed. Therefore, even when a high voltage is applied to drain region 16 in order to turn such lateral JFET 10 off, leakage current can be suppressed with a short channel length. As a result, the channel resistance can be reduced, thus an ON resistance can be reduced. Further, since there is no increase in an impurity concentration in buffer layer 11 except in its top portion, buffer layer 11 does not have a reduced vertical withstand voltage.

Further, the above-described barrier region 13 is not formed in a region under drain region 16. Thus, in the region under drain region 16, there is no limitation of the extension of depletion layer 19 caused by the presence of such barrier region 13. Thus, the occurrence of a problem of a reduced withstand voltage caused by an insufficient extension of a depletion layer, which arises if there is barrier region 13 in the region under drain region 16, can be prevented.

In the above-described lateral JFET 10, barrier region 13 is arranged to overlap gate region 17 in plan view and to extend to outside an outer peripheral end of gate region 17. Preferably, a distance T2 between an outer peripheral end of barrier region 13 and the outer peripheral end of gate region 17 in a direction along the surface of barrier region 13 facing channel layer 12 is not less than a thickness T1 of channel layer 12 in a region located under gate region 17 (namely, not less than the distance between the bottom of gate region 17 and the upper surface of barrier region 13). Here, a thickness of channel layer 12 is defined as a thickness of channel layer 12 in a direction along the layer stack direction of buffer layer 11 and channel layer 12, which corresponds to, seen from a different viewpoint, the distance from a buffer-layer-side bottom wall of gate region 17 to the surface of barrier region 13 located under this gate region 17.

In this case, since barrier region 13 is formed with a sufficient spread in a region under gate region 17, the expansion of depletion layer 19 beneath gate region 17 is restricted, allowing for more reliable prevention of generation of leakage current to drain region 16.

It is desirable that thickness d of barrier region 13 be within a thickness range which does not produce the tunnel effect, i.e., thicker than the thickness that produces the tunnel effect of carriers between the barrier region and channel layer 12. If thickness d of barrier region 13 is so thin as to produce the tunnel effect, then the depletion layer in buffer layer 11 is hardly affected, and it cannot be expected that barrier region 13 exerts a suppressing effect on the expansion of depletion layer. That is, if thickness d of barrier region 13 is less than 0.01 µm, for example, then the tunnel effect is produced and the expansion of depletion layer 19 is not suppressed. However, when thickness d of barrier region 13 is made above 0.2 µm, for example, while the expansion of the depletion layer can be suppressed, the withstand voltage is deteriorated. Therefore, it is desirable that thickness d of barrier region 13 be between 0.01 µm and 0.1 µm, which neither produces the tunnel effect nor deteriorates the withstand voltage.

Further, when barrier region 13 has a higher concentration of the p-type impurity, which is an impurity of a first conductivity type, than the n-type impurity concentration of channel layer 12, an electric field concentration is caused at a junction (pn junction) between barrier region 13 and channel layer 12. Here, if barrier region 13 has an impurity concentration value approximately equal to or less than the extent of that of channel layer 12, then the depletion layer spreads to buffer layer 11 and the field intensity of the pn junction is suppressed. On the other hand, if barrier region 13 has a higher impurity concentration value than that of channel layer 12, the depletion layer remains within barrier region 13 and does not expand to buffer layer 11. This causes an electric field concentration at the pn junction. Such an electric field concentration results in deterioration of a withstand voltage performance. Therefore, it is desirable that barrier region 13 be made to have the concentration of the p-type impurity, which is an impurity of the first conductivity type, approximately equal to or less than the n-type impurity concentration of channel layer 12.

Next, a method for manufacturing lateral JFET 10 shown in Fig. 1 will be described. In the method for manufacturing lateral JFET 10 according to the present invention, the following steps are performed. First, SiC substrate 1 as a semiconductor substrate is provided (S10). For example, an n-type substrate of 4H-SiC is provided as SiC substrate 1. Buffer layer 11 which is located on a main surface of SiC substrate 1 and made of a SiC layer including a p-type impurity as an impurity of a first conductivity type is then formed (S20). Buffer layer 11 is made to have a thickness of 10 µm, for example, and an epitaxial growth method can be used as a film forming method. Here, aluminum (Al) is used as a p-type impurity. Buffer layer 11 is made to have a p-type impurity concentration of, for example, 1.0×10¹⁶ cm⁻³.

In a portion of a surface layer of buffer layer 11, barrier region 13 including a p-type impurity having a higher concentration than the concentration of the impurity of the first conductivity type (p-type) in buffer layer 11 is then formed (S30). Specifically, a patterned resist film is formed on the surface of buffer layer 11 using a photolithography method, and using the resist film as a mask, aluminum (Al) is injected into a portion of the surface layer of buffer layer 11 by an ion implantation method. In this way, barrier region 13 of p-type conductivity is formed. An injection depth of Al (i.e. thickness d of barrier region 13) is made to be 0.1 µm, for example, and the p-type impurity concentration in this barrier region 13 is made to be 1.0×10¹⁷ cm⁻³.

Channel layer 12 located on buffer layer 11 in which barrier region 13 has been formed and including an impurity of a second conductivity type (n-type) having a higher concentration than the concentration of the p-type impurity in buffer layer 11 is then formed (S40). Here, nitrogen (N) is used as an n-type impurity. Channel layer 12 may have a thickness of 0.65 µm, for example. Further, channel layer 12 may have a concentration of the n-type conductive impurity of 2.0×10¹⁷ cm⁻³ In a surface layer of channel layer 12, gate region 17 including an impurity of the first conductivity type (p-type) is formed (S50). Specifically, a patterned resist film is formed using a photolithography method. By means of use of the resist film as a mask, aluminum (Al) is injected into the surface layer of channel layer 12 using an ion implantation method. In this way, gate region 17 of p-type conductivity is formed. Gate region 17 may have a thickness of 0.4 µm, for example. Further, gate region 17 may have a p-type conductive-impurity concentration of, for example, 1.0×10¹⁹ cm⁻³

In the surface layer of channel layer 12, source region 15 and drain region 16 including an impurity of the second conductivity type (n-type) are then formed to oppose to each other with gate region 17 interposed therebetween (S60). Specifically, as in the above-described step for forming gate region 17, source region 15 and drain region 16 of n-type conductivity are formed by injecting phosphorus (P) into the surface layer of channel layer 12 using an ion implantation method. Source region 15 and drain region 16 may have a depth of 0.4 µm, for example. Source region 15 and drain region 16 may have an n-type impurity concentration of, for example, 5.0×10¹⁹ cm⁻³ In the above-indicated step for forming barrier region 13 (S30), barrier region 13 is formed in either a region to be located under gate region 17 or a region to be located under gate region 17 and source region 15.

Activation annealing for activating ions implanted into the above-described gate region 17, source region 15, and drain region 16 is then performed (S70). As to conditions for the activation-annealing step, for example, argon gas may be used as an ambient gas, and a heating temperature of 1700°C and a heating time of 30 minutes may be employed. It is noted that the ambient pressure in annealing may be 100 kPa, for example. Field oxide film 20 is then formed (S80). Specifically, the surface of channel layer 12 is thermally oxidized to form field oxide film 20 by heating, in an oxygen ambient gas, SiC substrate 1 which has been subjected to the above-described processes. As to heating conditions, for example, a heating temperature of 1300°C and a heating time of 60 minutes may be employed. It is noted that the ambient pressure in heating may be at the atmospheric pressure. As a result, field oxide film 20 having a thickness of 0.1 µm is formed.

Opening 21 is then formed in a predetermined region of field oxide film 20 (S90). Specifically, a resist film having a predetermined pattern is formed on field oxide film 20 using a photolithography method. This resist film has an opening pattern formed in a region in which opening 21 (see Fig. 1) is to be formed. Using this resist film as a mask, field oxide film 20 is partially removed by etching. In this way, opening 21 is formed.

Ohmic electrode 22 is then formed within opening 21 (S100). Specifically, a conductive material film (for example, a nickel (Ni) film) constituting ohmic electrode 22 is formed within opening 21 and on the upper surface of the resist film using an evaporation method. Subsequently, by removing the resist film, a portion of the Ni film formed on the resist film is also removed (lift-off procedure). Then, by heat processing, in an argon ambient gas, the SiC substrate on which the Ni film has been formed, the Ni film is turned into ohmic electrode 22. As to the conditions for this heat processing, for example, a heating temperature of 950°C and a heating time of 2 minutes may be employed. Further, the pressure of the argon ambient gas may be at the atmospheric pressure.

Source pad 25, drain pad 26, and gate pad 27 are then formed (S 110). Specifically, a patterned resist film is formed on ohmic electrode 22 using a photolithography method. The resist film has an opening pattern formed to expose the above-described ohmic electrode 22. A conductive material film (for example, an aluminum film) to turn into source pad 25, drain pad 26, and gate pad 27 is formed by evaporation onto the interior of the opening pattern of the resist film and onto the upper surface of the resist film. Subsequently, a portion of the conductive material film located on the resist film is removed by removing the resist film (lift-off procedure). As a result, source pad 25, drain pad 26, and gate pad 27 located on ohmic electrodes 22 are obtained. In this way, the lateral JFET shown in Fig. 1 can be obtained.

Next, referring to Fig. 2, a modification of lateral JFET 10 shown in Fig. 1 will be described. Lateral JFET 10 shown in Fig. 2 basically includes the same structure as lateral JFET 10 shown in Fig. 1, but differs in the region where barrier region 13 is formed. Specifically, lateral JFET 10 shown in Fig. 2 has barrier region 13 formed to extend from a region under gate region 17 to even a region under source region 15. With such a configuration, the same effect as that of lateral JFET 10 shown in Fig. 1 can also be achieved. Further, since barrier region 13 extends to even under source region 15, no path reaches drain region 16 from source region 15 via buffer layer 11 without passing through barrier region 13, and therefore, the generation of leakage current can be more reliably prevented.

A method for manufacturing lateral JFET 10 shown in Fig. 2 is basically the same as the method for manufacturing lateral JFET 10 shown in Fig. 1, but differs in a pattern configuration of a resist film for performing an ion implantation method in the above-described step of forming barrier region 13 (S30). Specifically, for the resist film in the above-indicated step (S30) in the method for manufacturing lateral JFET 10 shown in Fig. 1, an opening pattern is formed in a region in which barrier region 13 shown in Fig. 1 is to be formed (only in a region to be located under gate region 17). On the other hand, in the above-indicated step (S30) in the method for manufacturing lateral JFET 10 shown in Fig. 2, as a pattern of a resist film, an opening pattern is formed to extend from under gate region 17 to a region located under source region 15. As a result, barrier region 13 shown in Fig. 2 can be formed by injecting an impurity of p-type conductivity (for example, Al) using the resist film as a mask. It is noted that other manufacturing steps are the same as the manufacturing steps in the method for manufacturing lateral JFET 10 shown in Fig. 1. In this way, lateral JFET 10 shown in Fig. 1 can be readily obtained.

### Second Embodiment

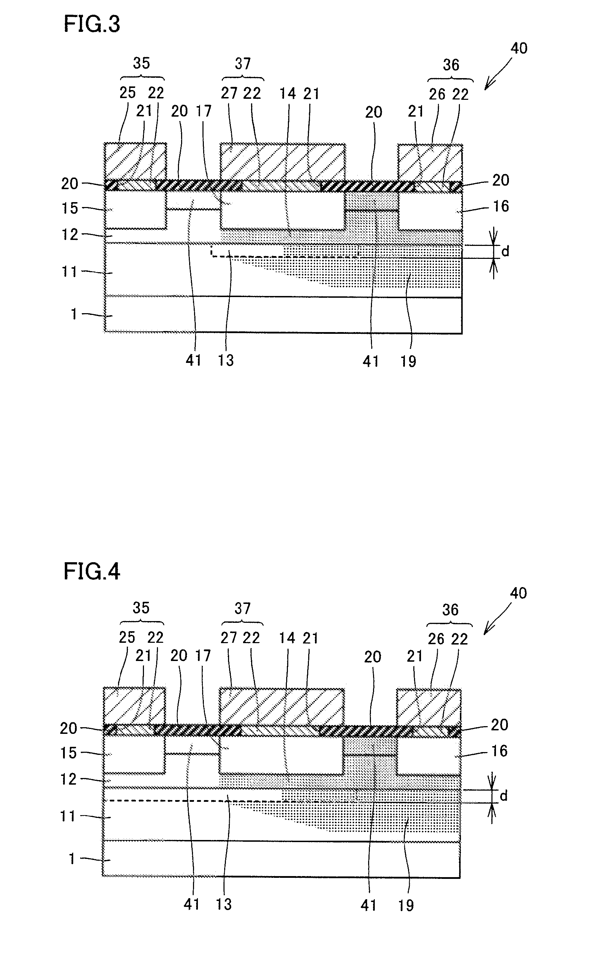

Referring to Fig. 3, a second embodiment of a lateral junction field-effect transistor (lateral JFET) 40 according to the present invention will be described. Lateral JFET 40 shown in Fig. 3 is a so called lateral RESURF-JFET (REduced SURface Field Junction Field Effect Transistor), and has the same basic configuration as that of lateral JFET 10 shown in Fig. 1, but differs from lateral JFET 10 shown in Fig. 1 in that a RESURF layer 41 of p-type conductivity is formed in a surface layer of channel layer 12 and between source region 15, drain region 16, and gate region 17. RESURF layer 41 has a higher concentration of an impurity of p-type conductivity than the concentration of a conductive impurity in buffer layer 11. Further, it is preferable that RESURF layer 41 has a higher concentration of the impurity of p-type conductivity than the concentration of conductive impurity in barrier region 13. As such, since a depletion layer extends from a RESURF layer 41 side of the channel layer in upward and downward directions in a region between gate region 17 and drain region 16, the electric field distribution in this region will be the electric field distribution of a uniform electric field, which is just close to a parallel plate capacitor. This allows for reducing an ON resistance while maintaining a withstand voltage, as compared with a JFET which does not form RESURF layer 41. Also in lateral JFET 40 with such RESURF layer 41, barrier region 13 is formed in the same manner as in lateral JFET 10 shown in Fig. 1, and therefore, the same effect as in lateral JFET 10 shown in Fig. 1 can be achieved.

Next, a method for manufacturing lateral JFET 40 shown in Fig. 3 will be described. The method for manufacturing lateral JFET 40 shown in Fig. 3 is basically the same as the method for manufacturing lateral JFET 10 shown in Fig. 1, but differs from the method for manufacturing lateral JFET 10 shown in Fig. 1 in that a step of forming RESURF layer 41 is added. Specifically, the steps (S10)-(S30) in the method for manufacturing lateral JFET 10 shown in Fig. 1 are performed. Subsequently, as in the above-described step (S40), channel layer 12 located on buffer layer 11 in which barrier region 13 is formed and including an impurity of the second conductivity type (n-type) having a higher concentration than the concentration of a p-type impurity in buffer layer 11 is formed. It should be noted that channel layer 12 formed here has a thickness of 0.4 µm, for example. Channel layer 12 may have the concentration of an n-type conductivity impurity of 2.0×10¹⁷ cm⁻³.

Subsequently, RESURF layer 41 is formed on channel layer 12 (S45). RESURF layer 41 includes an impurity of the first conductivity type (p-type) having a higher concentration than the concentration of the p-type impurity in buffer layer 11. RESURF layer 41 may have a thickness of 0.25 µm, for example, and RESURF layer 41 may have a concentration of the p-type conductivity impurity of 2.0×10¹⁷ cm⁻³.

Subsequently, lateral JFET 40 shown in Fig. 3 can be obtained by performing the above-described steps (S50)-(S110) as in the method for manufacturing lateral JFET 10 shown in Fig. 1. It is noted that in the steps for manufacturing lateral JFET 40 shown in Fig. 3, when performing the steps corresponding to the above-indicated steps (S50) and (S60), gate region 17, source region 15, and drain region 16 are formed to extend through RESURF layer 41 to channel layer 12.

Next, referring to Fig. 4, a modification of lateral JFET 40 shown in Fig. 3 will be described. Lateral JFET 40 shown in Fig. 2 basically includes the same structure as lateral JFET 40 shown in Fig. 3, but differs in the region where barrier region 13 is formed. Specifically, lateral JFET 10 shown in Fig. 4 has barrier region 13 formed to extend from a region under gate region 17 to even a region under source region 15, as in lateral JFET 10 shown in Fig. 2. With such a configuration, the same effect as that of lateral JFET 10 shown in Fig. 3 can also be achieved, and additionally, the same effect as that of lateral JFET 10 shown in Fig. 2 can be achieved.

A method for manufacturing lateral JFET 40 shown in Fig. 4 is basically the same as the method for manufacturing lateral JFET 40 shown in Fig. 3, but differs in a pattern configuration of a resist film for performing an ion implantation method in the above-described step of forming barrier region 13 (S30). Specifically, for the resist film in the above-indicated step (S30) in a method for manufacturing lateral JFET 40 shown in Fig. 3, an opening pattern is formed in a region in which barrier region 13 shown in Fig. 3 is to be formed (only in a region to be located under gate region 17). On the other hand, in the above-indicated step (S30) in the method for manufacturing lateral JFET 40 shown in Fig. 4, as a pattern of a resist film, an opening pattern is formed to extend from under gate region 17 to a region located under source region 15. As a result, barrier region 13 shown in Fig. 4 can be formed by injecting an impurity of p-type conductivity (for example, Al) using the resist film as a mask. It is noted that other manufacturing steps are the same as the manufacturing steps in the method for manufacturing lateral JFET 40 shown in Fig. 3. In this way, lateral JFET 10 shown in Fig. 4 can be readily obtained.

Here, characteristic features of the present invention will be listed, although a portion thereof partly overlaps the above-described embodiments.

A lateral JFET 10, 40 according to the present invention includes SiC substrate 1 as a semiconductor substrate, buffer layer 11, channel layer 12, source region 15, drain region 16, gate region 17, and barrier region 13. Buffer layer 11 is located on a main surface of SiC substrate 1 and includes an impurity of a first conductivity type (p-type). Channel layer 12 is located on buffer layer 11 and includes an impurity of a second conductivity type (n-type) having a higher concentration than the concentration of the impurity of the first conductivity type in buffer layer 11. Source region 15 and drain region 16 are formed to be spaced from each other in a surface layer of channel layer 12 and include an impurity of the second conductivity type (n-type). Gate region 17 is located in the surface layer of channel layer 12 and between source region 15 and drain region 16 and includes an impurity of the first conductivity type (p-type). Barrier region 13 is arranged in an interface region between channel layer 12 and buffer layer 11 and in either a region located under gate region 17 or a region extending from under gate region 17 to under source region 15 and includes a p-type impurity having a higher concentration than the concentration of the p-type impurity in buffer layer 11.

As such, a junction (pn junction) between barrier region 13 including the p-type impurity and a surrounding region including the n-type impurity (for example, a drain-region-16-side portion of channel layer 12) are formed. The p-type impurity in barrier region 13 side in this pn junction has a higher concentration than the concentration of the p-type impurity in buffer layer 11. This results in that even when a high reverse bias voltage is applied to the junction, the length of extension of the depletion layer into barrier region 13 side (depletion layer width) is shorter than when buffer layer 11 and channel layer 12 form a direct pn junction (i.e., without barrier region 13). Further, since barrier region 13 is formed to extend under gate region 17 or from under gate region 17 to under source region 15, the depletion layer can be suppressed so as not to extend so close to source region 15 that depletion layer 19 may draw carriers from this source region 15 across buffer layer 11 beneath channel region 14. Further, the impurity concentration in barrier region 13 can be determined (for example, in consideration of correlation with impurity concentrations in other regions) such that the scope of expansion of depletion layer 19 is restricted so as not to generate drawing of carriers in depletion layer 19. As such, since the extension of depletion layer 19 in barrier region 13 along the bottom of channel region 14 is suppressed, barrier region 13 acts as a potential barrier for carriers. Consequently, leak current to drain region 16, which results from a carrier injection from source region 15 into buffer layer 11, can be prevented.

Further, the above-described barrier region 13 is not formed in a region under drain region 16. Thus, in the region under drain region 16, there is no limitation of the extension of depletion layer 19 caused by the presence of such barrier region 13. Therefore, the occurrence of a problem of a reduced withstand voltage which would arise if there were barrier region 13 in the region under drain region 16, can be prevented. It is noted that the above-described barrier region 13 may be formed in a surface layer of buffer layer 11 or may be formed as a thin film layer stacked on buffer layer 11.

In the above-described lateral JFET 10, 40, barrier region 13 may be arranged to overlap gate region 17 in plan view and to extend to outside an outer peripheral end of gate region 17. Distance T2 between an outer peripheral end of barrier region 13 and the outer peripheral end of gate region 17 in a direction along the surface of barrier region 13 facing channel layer 12 may be not less than thickness T1 of channel layer 12 in a region located under gate region 17. Here, thickness T1 of channel layer 12 is defined as a thickness of channel layer 12 in a direction along the layer stack direction of buffer layer 11 and channel layer 12, which corresponds to, seen from a different viewpoint, the distance from a buffer-layer-side bottom wall of gate region 17 to the surface of barrier region 13 located under this gate region 17.

In this case, since barrier region 13 is formed with a sufficient spread in a region under gate region 17, the expansion of depletion layer 19 beneath gate region 17 is restricted, allowing for more reliable prevention of generation of leakage current to drain region 16. It is noted that the reason the lower limit of distance T2 between the outer peripheral end of barrier region 13 and the outer peripheral end of gate region 17 is defined as thickness T1 of channel layer 12 under gate region 17 is that in order to turn a transistor OFF, the depletion layer in channel layer 12 needs to spread away from the pn junction between channel layer 12 and gate region 17 by at least not less than thickness T1 of channel layer 12.

In the above-described lateral JFET 10, 40, it is desirable that barrier region 13 has thickness d which is thicker than the thickness that produces the tunnel effect of carriers between the barrier region and channel layer 12. Here, a thickness of barrier region 13 is defined as a thickness of barrier region 13 in a direction along the layer stack direction of buffer layer 11 and channel layer 12. In this case, since the production of the tunnel effect can be prevented, the occurrence of a problem that a leakage-current-suppressing effect is not exerted in barrier region 13 due to the tunnel effect, can be prevented.

In other words, if the thickness of barrier region 13 is so thin as to produce the tunnel effect, then the depletion layer in buffer layer 11 is hardly affected, and it cannot be expected that barrier region 13 exerts a suppressing effect on the expansion of depletion layer. That is, if the thickness of barrier region 13 is so thin that the tunnel effect is produced, then the expansion of depletion layer 19 is hardly suppressed by the presence of barrier region 13. Further, when the thickness of barrier region 13 is thick, a withstand voltage is deteriorated. It is noted that in the above-described embodiments, barrier region 13 may have a thickness d of 0.1 µm, for example. It is preferable that the thickness d of barrier region 13 is made to be not less than 0.01 µm and less than 0.2 µm, and more preferably, not less than 0.01 µm and not more than 0.1 µm so that there is no tunnel effect and no deterioration of a withstand voltage.

In the above-described lateral JFET 10, 40, barrier region 13 may have a concentration of the impurity of the first conductivity type (p-type) which is not more than the concentration of the impurity of the second conductivity type (n-type) in channel layer 12. In this case, it is possible to allow the depletion layer to extend with a relatively large extent to the barrier region 13 side, without narrowing the width of a depletion layer formed at a pn junction in an interface between channel layer 12 and barrier region 13. As a result, an electric field concentration due to the absence of spreading of depletion layer 19 is prevented. Consequently, a decrease in a withstand voltage can be suppressed.

In the method for manufacturing lateral JFET 10, 40 according to the present invention, the following steps are performed. First, SiC substrate 1 as a semiconductor substrate is provided (S10). Buffer layer 11 located on the main surface of SiC substrate 1 and including an impurity of a first conductivity type (p-type) is then formed (S20). In a portion of a surface layer of buffer layer 11 or on the surface of buffer layer 11, barrier region 13 including an impurity of the first conductivity type (p-type) having a higher concentration than the concentration of the p-type impurity in buffer layer 11 is formed (S30). Channel layer 12 located on buffer layer 11 and including an impurity of a second conductivity type (n-type) having a higher concentration than the concentration of the p-type impurity in buffer layer 11 is formed (S40). In a surface layer of channel layer 12, gate region 17 including a p-type impurity is formed (S50). In the surface layer of channel layer 12, source region 15 and drain region 16 including an n-type impurity are formed to oppose to each other with gate region 17 interposed therebetween (S60). In the step for forming barrier region 13 (S30), barrier region 13 is formed in either a region to be located under gate region 17 or a region to extend from under gate region to under source region. In this way, lateral JFET 10, 40 in which a sufficient withstand voltage is provided and depletion layer 19 can be suppressed so as not to extend into buffer layer 11 to such an extent of drawing carriers from source region 15 even when a positive high voltage is applied to drain region 16, can be obtained.

It should be construed that embodiments disclosed herein are by way of illustration in all respects, not by way of limitation. It is intended that the scope of the present invention is defined by claims, not by the above description of the embodiments, and includes all modifications equivalent in meaning and scope to the claims.

### INDUSTRIAL APPLICABILITY

A lateral JFET according to the prevent invention is advantageously applied in particular to power electronics equipment such as a power switching device.

### DESCRIPTION OF THE REFERENCE SIGNS

1 SiC substrate, 10, 40 lateral JFET, 11 buffer layer, 12 channel layer, 13 barrier region, 14 channel region, 15 source region, 16 drain region, 17 gate region, 19 depletion layer, 20 field oxide film, 21 opening, 22 ohmic electrode, 25 source pad, 26 drain pad, 27 gate pad, 35 source electrode, 36 drain electrode, 37 gate electrode, 41 RESURF layer.

## Claims

1. A lateral junction field-effect transistor, comprising:
a semiconductor substrate (1);
a buffer layer (11) located on a main surface of said semiconductor substrate (1) and including an impurity of a first conductivity type;
a channel layer (12) located on said buffer layer (11) and including an impurity of a second conductivity type having a higher concentration than a concentration of said impurity of the first conductivity type in said buffer layer (11);
a source region (15) and a drain region (16) formed to be spaced from each other in a surface layer of said channel layer (12) and including an impurity of the second conductivity type;
a gate region (17) located in the surface layer of said channel layer (12) and between said source region (15) and said drain region (16) and including an impurity of the first conductivity type; and
a barrier region (13) arranged in an interface region between said channel layer (12) and said buffer layer (11) and in either a region located under said gate region (17) or a region extending from under said gate region (17) to under said source region (15), and including an impurity of the first conductivity type having a higher concentration than the concentration of said impurity of the first conductivity type in said buffer layer (11).

2. The lateral junction field-effect transistor according to claim 1, wherein
said barrier region (13) is arranged to overlap said gate region (17) in plan view and to extend to outside an outer peripheral end of said gate region (17),
a distance between an outer peripheral end of said barrier region (13) and the outer peripheral end of said gate region (17) in a direction along a surface of said barrier region (13) facing said channel layer (12) is not less than a thickness of said channel layer (12) in the region located under said gate region (17).

3. The lateral junction field-effect transistor according to claim 1, wherein
said barrier region (13) has a thickness which is thicker than a thickness which produces tunnel effect of carriers between said barrier region and said channel layer (12).

4. The lateral junction field-effect transistor according to claim 1, wherein
said barrier region (13) has a concentration of said impurity of the first conductivity type which is not more than the concentration of said impurity of the second conductivity type in said channel layer (12).
